# FASCICULE DE BREVET EUROPEEN

(11) **EP 3 336 980 B1**
(45) Date de publication et mention de la délivrance du brevet: **28.08.2019**
(21) Numéro de dépôt: 17172373.7
(22) Date de dépôt: 23.05.2017
(51) Int. Cl.: H01S 5/042, H01S 5/42, G01S 17/10, G01S 17/32, G01S 17/89, G01S 7/481, G01S 7/491, H01S 5/062, H01S 5/183, H01S 5/40

(54) **PROCÉDÉ D'ÉMISSION OPTIQUE SINUSOÏDALE, ET CIRCUIT CORRESPONDANT**
VERFAHREN EINER OPTISCHEN SINUSFÖRMIGEN EMISSION, UND ENTSPRECHENDER SCHALTKREIS
SINUSOIDAL OPTICAL EMISSION METHOD, AND CORRESPONDING CIRCUIT

(30) Priorité: 16.12.2016 FR 1662640
(43) Date de publication de la demande: 20.06.2018
(73) Titulaire: STMicroelectronics (ALPS) SAS, 38000 Grenoble (FR)
(72) Inventeur: BRANCA, Xavier, 38360 SASSENAGE (FR)
(74) Mandataire: Casalonga

(56) Documents cités:
- US-A1- 2014 362 364
- US-A1- 2015 362 585
- US-B1- 6 822 687

## Description

Des modes de mise en oeuvre et de réalisation de l'invention concernent les circuits électroniques, et plus particulièrement les circuits d'émission optique, en particulier équipés de diodes laser à émission de surface et cavité verticale communément connu par l'homme du métier sous l'acronyme anglo-saxon (« VCSEL ») (« Vertical Cavity Surface Emitting Laser » en anglais), destiné à émettre des signaux optiques sinusoïdaux.

Un tel circuit d'émission optique est incorporable par exemple dans des appareils électroniques du type tablette ou téléphone mobile cellulaire pour des applications basées sur un principe du temps de vol indirect, communément connu par l'homme du métier sous l'acronyme anglo-saxon « iToF » (« Indirect Time of Flight » en anglais), ou sur un principe de communication sans fil basé sur l'utilisation d'une lumière visible, communément connu par l'homme du métier sous l'acronyme anglo-saxon « LiFi » (« Light Fidelity » en anglais).

En général, un circuit d'émission optique apte à appliquer le principe du temps de vol indirect (« iToF ») émet des impulsions optiques, par exemple par un rayonnement optique infrarouge en créneaux, vers une scène. Des éléments bidimensionnels voire tridimensionnels de la scène renvoient ces impulsions optiques vers un capteur dudit circuit ayant un réseau de pixels de détection. Les déphasages des impulsions optiques entre l'émission et la réception de ces impulsions sont mesurés par le capteur de façon à déterminer indirectement les temps de vol de ces impulsions et les distances entre les éléments de la scène et le circuit, ce qui permet avantageusement de réduire l'encombrement et le coût dudit circuit tout en conservant une précision raisonnable par rapport à un capteur équivalent de type « temps de vol direct ».

Il est fait référence à ce sujet aux documents de l'art antérieur suivants: US2014/0362364 A1, US6822687 B1 et US2015/0362858 A1.

Toutefois il existe un besoin d'effectuer une telle mesure de déphasage pour des signaux optiques sinusoïdaux, ce qui est avantageusement plus simple que pour des signaux optiques en créneaux.

Ainsi, selon un mode de mise en oeuvre et de réalisation, il est proposé d'offrir une solution technique à faible complexité pour piloter un circuit d'émission optique sinusoïdale comportant des diodes laser émettant des signaux optiques à une fréquence pouvant aller jusqu'à 500 MHz avec une puissance moyenne pouvant aller jusqu'à dix watts.

Selon un aspect, il est proposé un procédé de commande d'un réseau de M sources optiques. Les M sources optiques sont réparties en N groupes, avec N inférieur à M. Ce procédé comprend des cycles d'activations/désactivations respectives et séquentielles de toutes les sources optiques des N groupes à partir de N signaux de commande en créneaux périodiques successivement mutuellement déphasés de Pi/N et ayant tous la même période. Chaque signal de commande possède un premier état, un deuxième état, la même période, et un rapport cyclique de 1/2. Chaque groupe est activé lorsque le signal de commande correspondant est dans son premier état et désactivé lorsque le signal de commande est dans son deuxième état. Le nombre de sources optiques dans chaque groupe et l'ordonnancement des groupes dans la séquence des activations/désactivations sont choisis de façon à générer un signal optique dont l'amplitude varie par palier selon une évolution sinusoïdale.

Les N signaux de commande peuvent être par exemple générés à partir d'un signal de référence ayant avantageusement mais non nécessairement la même période que celle des signaux de commande. Le courant total circulant dans toutes les sources optiques des N groupes est régulé en fonction du produit d'un courant de référence par le rapport cyclique du signal de référence.

Un tel procédé permet avantageusement d'émettre, à partir d'un signal de référence en créneau, un signal optique d'amplitude sinusoïdale à une haute fréquence et avec une puissance moyenne élevée.

Par ailleurs, ici les N signaux de commande sont configurés pour avoir un rapport cyclique de 1/2 de façon à assurer la symétrie du signal optique sinusoïdal.

A titre préférentiel mais non limitatif, chaque cycle de séquences d'activations/désactivations commence par une activation d'un nombre initial de groupes contenant ensemble un pourcentage de sources optiques du réseau de sources optiques égal au rapport cyclique du signal de référence.

Avantageusement, les activations/désactivations séquentielles et périodiques des différents groupes correspondants de sources optiques provoquent une variation de l'intensité optique globale des impulsions optiques générées par les sources optiques du réseau. Cette variation de l'intensité optique globale est liée directement à la variation du courant total circulant dans toutes les sources optiques des N groupes. Lorsque la variation du courant total a la forme d'un signal sinusoïdal comme on le verra plus loin dans la description, ladite intensité optique globale génère un signal optique dont l'amplitude varie par palier selon une évolution sinusoïdale. L'amplitude maximale de ce signal optique est atteinte lorsque toutes les M sources optiques du réseau sont simultanément activées. A ce moment là, l'amplitude du courant total est égale à celle du courant de référence.

Les sources optiques du réseau peuvent avantageusement être des diodes laser à émission de surface et cavité verticale.

Selon un autre aspect, il est proposé un circuit d'émission optique. Ce circuit comprend
- un réseau de M sources optiques réparties en N groupes, avec N inférieur à M, et
- des moyens de commande configurés pour générer N signaux de commande en créneaux périodiques successivement mutuellement déphasés de Pi/N et ayant tous la même période, chaque signal de commande ayant un premier état, un deuxième état, et un rapport cyclique de 1/2, et pour cycliquement activer/désactiver toutes les sources optiques des N groupes respectivement et séquentiellement à partir des N signaux de commande.

Chaque groupe est activé lorsque le signal de commande correspondant est dans son premier état et désactivé lorsque le signal de commande est dans son deuxième état. Le nombre de sources optiques dans chaque groupe et l'ordonnancement des groupes dans la séquence des activations/désactivations sont choisis de façon à générer un signal optique dont l'amplitude varie par palier selon une évolution sinusoïdale.

Selon un mode de réalisation, les moyens de commande comportent une source de signaux configurée pour générer les N signaux de commande à partir d'un signal de référence ayant avantageusement la même période que celle des signaux de commande, et N commutateurs couplés entre une source d'alimentation commandée par un moyen de régulation et les N groupes de sources optiques, le moyen de régulation étant configuré pour réguler le courant total circulant dans toutes les sources optiques des N groupes en fonction du produit d'une courant de référence par le rapport cyclique du signal de référence.

Selon un mode de réalisation les moyens de commande sont configurés pour faire débuter chaque cycle de séquences d'activations/désactivations par une activation d'un nombre initial de groupes contenant ensemble un pourcentage de sources optiques du réseau de sources optiques égal au rapport cyclique du signal de référence.

A titre indicatif mais non limitatif, le circuit peut par exemple comprendre en outre un bloc de commande configuré pour délivrer au moyen de régulation un courant de référence.

Selon un autre mode de réalisation, le moyen de régulation comporte un filtre passe bas ayant une fréquence de coupure dont le rapport avec la fréquence du signal de référence est inférieur à 1/10.

Par ailleurs, avantageusement, les sources optiques d'un même groupe du réseau ne sont mutuellement pas en contact.

Autrement dit, les sources optiques d'un même groupe sont dispersées dans tout le réseau de sorte qu'elles ne soient en contact direct qu'avec les sources optiques d'un autre groupe, ce qui permet d'obtenir l'émission d'un signal optique sinusoïdal plus homogène.

Selon encore un autre mode de réalisation, les sources optiques du réseau sont des diodes laser à émission de surface et cavité verticale (« VCSEL »).

Par ailleurs, le circuit d'émission optique peut également être réalisé de façon intégrée.

Selon un autre aspect, il est proposé un émetteur destiné à appliquer le principe du temps de vol indirect et incorporant un circuit d'émission tel que défini ci-avant.

Selon encore un autre aspect, il est proposé un appareil électronique, par exemple du type tablette ou téléphone mobile cellulaire, incorporant un émetteur tel que défini ci-dessus.

D'autres avantages et caractéristiques de l'invention apparaîtront à l'étude de la description détaillée de modes de mise en oeuvre et de réalisation, pris à titre d'exemples non limitatifs et illustrés par les dessins annexés sur lesquels :

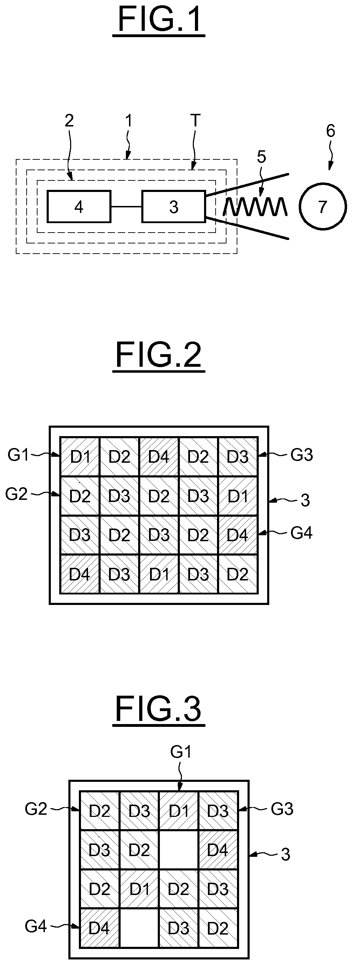

Les figures 1 à 6 sont relatives à différents modes de mise en oeuvre et de réalisation de l'invention.

La figure 1 illustre schématiquement un appareil électronique 1 du type téléphone mobile cellulaire incorporant un émetteur optique T configuré pour appliquer le principe du temps de vol indirect (« iToF » en anglais). Ledit émetteur T incorpore lui-même un circuit d'émission optique 2 selon un mode de réalisation de l'invention. Il convient de noter que l'appareil électronique 1 comprend en outre un capteur (non présenté) qui peut être réalisé dans un même circuit intégré que l'émetteur T ou dans un circuit intégré différent.

Le circuit d'émission optique 2 comprend un moyen d'émission optique, ici par exemple un réseau de sources optiques 3 comportant M sources optiques, ici des diodes laser à émission de surface et cavité verticale (« VCSEL »), dont des exemples d'agencement sont illustrés en détails sur les figures 2 et 3, et des moyens de commande 4 configurés pour commander le réseau de sources optiques 3 de façon à ce qu'il émette un signal optique 5 dont l'amplitude varie par paliers selon une évolution sinusoïdale vers une scène 6 en vue de déterminer indirectement le temps de vol du signal optique 5 en mesurant le déphasage du signal optique 5 entre l'émission et la réception de ce signal 5 à la suite de sa réflexion sur des objets 7 dans la scène 6.

On se réfère maintenant aux figures 2 et 3 pour illustrer plus en détails, des modes de réalisation possibles du réseau de sources optiques 3.

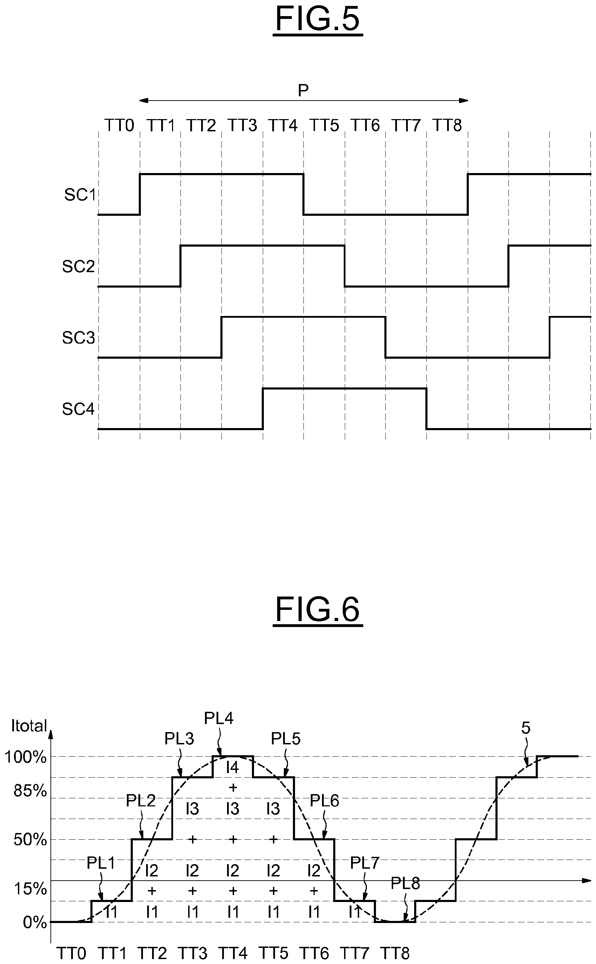

La figure 2 illustre un réseau comportant ici par exemple 20 diodes laser (« VCSEL »). Afin de générer le signal optique 5 qui sera détaillé plus loin dans la description et sur la figure 6, le réseau de sources optiques 3, matriciel, est partitionné en N groupes, par exemple en quatre groupes indépendants G1 à G4.

Par ailleurs, chaque groupe du réseau 3 comporte un certain nombre de diodes laser. A titre d'exemple non limitatif, le premier et le quatrième groupes G1 et G4 comportent chacun trois diodes laser D1 et D4 tandis que le deuxième et le troisième groupes G2 et G3 comportent chacun sept diodes laser D2 et D3. De ce fait, les quatre groupes représentent respectivement 15%, 35%, 35% et 15% du nombre total de diodes laser, ici vingt sources optiques, dans le réseau 3.

Comme on va le voir ci-après, au cours d'un cycle de commande, les groupes G1 à G4 sont activés séquentiellement un à un, les uns après les autres dans un ordre d'activation prédéfini de sorte que le nombre de groupes activés s'incrémente de un jusqu'à ce que tous les groupes soient activés. Lorsqu'un groupe Gi est activé, toutes les diodes laser Di du groupe activé Gi sont activées.

Puis les groupes sont désactivés séquentiellement un à un, les uns après les autres dans un ordre de désactivation qui est l'inverse de l'ordre d'activation, de sorte que le nombre de groupe activés se décrémente de un jusqu'à ce que tous les groupes soient désactivés.

Lorsqu'un groupe Gi est désactivé, toutes les diodes laser Di du groupe désactivé sont désactivées.

On répète plusieurs fois le cycle de commande, et le nombre de diodes laser dans chaque groupe G1 à G4 et l'ordonnancement de ces groupes G1 à G4 dans les séquences d'activation et de désactivation sont avantageusement choisis de façon à générer le signal optique 5.

Le point de départ d'un cycle de commande, qui est également le point d'arrivée de ce cycle, n'est pas nécessairement celui correspondant à une activation d'aucun des groupes, mais peut être en pratique et préférentiellement celui correspondant à une activation d'un nombre initial de groupes, par exemple deux groupes, contenant ensemble un certain pourcentage de diodes laser du réseau de diodes laser, comme on le verra plus en détails ci-après.

En variante, la figure 3 illustre un autre mode de réalisation du réseau comportant 14 diodes divisées également en quatre groupes G1 à G4.

Dans cet agencement de diodes du réseau 3, le premier et le quatrième groupes G1 et G4 comportent chacun deux diodes laser D1 et D4 tandis que le deuxième et le troisième groupes G2 et G3 comportent chacun cinq diodes laser D2 et D3. De ce fait, les quatre groupes représentent respectivement environ 14%, 36%, 36% et 14% du nombre total de diodes laser, ici quatorze sources optiques, dans le réseau 3. Les cases blanches illustrées sur la figure 3 signifient une non-présence de diode dans cette position du réseau 3.

Avantageusement, l'agencement de diodes du réseau 3 illustré sur la figure 3 est capable de générer le signal optique 5 dans l'amplitude varie par palier et correspond au mieux à une évolution sinusoïdale

Comme illustré sur les figures 2 et 3, les diodes laser d'un même groupe ne sont pas mutuellement en contact afin de mieux disperser des diodes laser de chaque groupe G1 à G4 au sein du réseau 3. De ce fait, l'intensité optique globale d'impulsions optiques émises par les diodes laser du réseau 3 est plus homogène dans l'espace vers la scène 6.

Il convient de noter que d'autres partitionnements du réseau 3 et d'autres ordonnancements d'activation/désactivation des sources optiques du réseau 3 sont également possibles pour générer des signaux optiques sinusoïdaux selon l'invention.

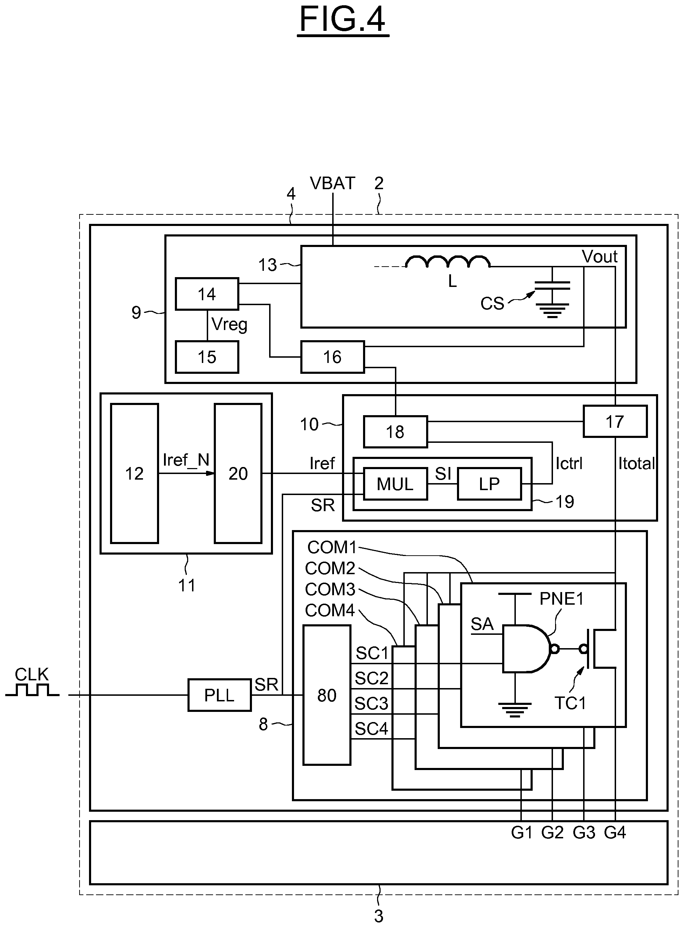

La figure 4 illustre un exemple détaillé de la structure interne du circuit d'émission optique 2.

Le circuit 2 comprend ledit réseau de sources optiques 3 déjà décrit sur la figure 2 ou 3 et les moyens de commande 4 dont un exemple de réalisation va être présentés en détails ci-dessous.

Les moyens de commande 4 comportent un étage d'entrée PLL destiné à recevoir un signal d'horloge externe CLK en créneaux et comprenant une boucle à verrouillage de phase (« Phase-Locked Loop » : PLL en anglais) configuré pour générer un signal de référence SR en créneaux à une fréquence pouvant aller par exemple jusqu'à 500 MHz.

Les moyens de commande 4 comportent en outre une source 8 de signaux de commande destinée à recevoir le signal de référence SR.

Il convient de noter que le signal de référence SR possède un rapport cyclique R valant préférentiellement mais non limitativement 1/2.

Par ailleurs, la source de signaux 8 comprend une boucle à verrouillage de retard (« Delay-Locked Loop » : DLL en anglais) 80 configurée pour générer à partir dudit signal de référence SR, N signaux de commande en créneaux, ici par exemple quatre signaux de commande, SC1 à SC4 à quatre commutateurs COM1 à COM4. Les signaux de commande SC1 à SC4 comportent chacun un rapport cyclique R de 1/2 et sont déphasés entre eux d'un déphasage Pi/N, soit Pi/4.

Les moyens de commande 4 comprennent en outre une source d'alimentation 9 couplée au réseau de sources optiques 3 via un moyen de régulation 10, et un bloc de commande 11 configuré pour délivrer au moyen de régulation 10 un courant de référence analogique Iref.

Lesdits commutateurs COM1 à COM4 sont avantageusement des commutateurs de puissance couplés entre les anodes des diodes laser D1 à D4 du réseau 3 et la tension d'alimentation de ces diodes D1 à D4, c'est-à-dire ici la tension de sortie Vout de la source alimentation 9.

Chaque commutateur COM1 à COM4 comporte un transistor de contrôle TC1 (TC2 à TC4 non présentés sur la figure 4) identique commandé par un circuit de pilotage, ici par exemple une porte de type NON-ET PNE1 (PNE2 à PNE4 non présentés sur la figure 4) dont une première entrée reçoit un signal d'autorisation SA, une deuxième entrée reçoit le signal de commande correspondant SCi et dont la sortie est couplée à la grille du transistor de contrôle TCi correspondant. Le drain de chaque transistor de contrôle TCi est couplé à toutes les diodes laser du groupe correspondant Gi au sein du réseau de source optique 3.

Lorsque les signaux de commande SC1 à SC4 sont dans leur état haut, les commutateurs COM1 à COM4 correspondants sont dans leur état passant de façon à activer les diodes laser correspondantes.

Lorsque le signal de commande SCi est dans son état bas, le commutateur COMi est bloqué et les diodes du groupe Gi sont désactivées.

Le bloc de commande 11 comprend ici par exemple un bloc de commande numérique 12 destiné à délivrer un courant de référence numérique Iref_n à un convertisseur numérique-analogique 20 de façon à former ledit courant de référence Iref.

La source d'alimentation 9 comprend
- une source d'alimentation à découpage 13 connue en soi dont l'inductance L est couplée à sa sortie et reliée à la masse par un condensateur de sortie CS, la source 13 étant alimentée par une tension d'alimentation VBAT et commandé par un moyen de modulation de largeur d'impulsion 14 (« Pulse Width Modulation » en anglais),
- un générateur de rampe 15 couplé audit moyen de modulation 14, et
- un moyen d'asservissement 16, ici par exemple un régulateur de type proportionnel-intégrateur-dérivateur PID en tension destiné à délivrer au moyen de modulation 14 une tension de régulation Vreg de façon à commander la tension de sortie Vout de la source alimentation à découpage 13 en fonction d'une tension de commande Vctrl produite par le moyen de régulation 10. Pour ce faire, la tension de sortie Vout est également délivrée à une entrée du moyen d'asservissement 16 en tant que tension de rétroaction.

La tension de sortie Vout est ici également utilisée pour alimenter toutes les portes NON-ET PNE1 (PNE2 à PNE4 non présentées sur la figure 3) de tous les commutateurs COM1 à COM4.Le moyen de régulation 10 comporte
- un capteur de courant 17 couplé entre la sortie de la source d'alimentation 9 et les quatre commutateurs COM1 à COM4 de la source de signaux 8,
- un régulateur PID en tension 18 couplé au capteur de courant 17 et à un étage de traitement 19 recevant le courant de référence Iref.

Le courant total Itotal circulant dans tous les commutateurs COM1 à COM4 est fourni par la source d'alimentation à découplage 13 et mesuré par le capteur de courant 17. Le capteur de courant 17 comporte en outre un étage de filtrage passe-bas (non présenté) configuré pour effectuer un filtrage passe-bas sur le courant total Itotal mesuré avant de le délivrer au régulateur PID 18.

L'étage de traitement 19 comprend par exemple un circuit de multiplicateur MUL recevant le courant de référence Iref et le signal de référence SR et configuré pour générer un signal intermédiaire SI.

Comme le rapport cyclique R du signal de référence SR est fixé ici à 1/2, la valeur moyenne du signal intermédiaire SI représente la moitié de celle du courant de référence Iref.

L'étage de traitement 19 comporte en outre un filtre passe-bas LP classique, configuré pour générer un courant de commande Ictrl.

Il convient de noter que la fréquence de coupure du filtre passe-bas LP et celle de l'étage de filtrage passe-bas sont avantageusement au moins dix fois plus petites que celle du signal de référence SR en créneaux. En d'autres termes, le rapport entre la fréquence de coupure du filtre LP ou celle de l'étage de filtrage et la fréquence du signal de référence SR en créneaux est inférieur à 1/10 de façon à suffisamment filtrer le courant de commande Ictrl et le courant total Itotal.

De ce fait, l'étage de traitement 19 reçoit la valeur moyenne du courant total <Itotal> et la valeur moyenne du courant de commande <Ictrl> = R^{∗}Iref = 0,5^{∗}Iref. La valeur moyenne du courant total <Itotal> est égale à la moitié de la valeur crête du courant total parce que ce signal Itotal est délivré au réseau 3 via les commutateurs COM1 à COM4 qui sont commandés par les signaux de commande SC1 à SC4 ayant chacun le rapport cyclique de 1/2.L'étage de traitement 19 est configuré pour ajuster la tension de commande Vctrl pour que les valeurs moyennes <Itotal> et <Ictrl> soient égales.

Ainsi, la valeur crête du courant total Itotal est égale à celle du courant de référence Iref.

On se réfère maintenant aux figures 5 et 6 pour illustrer un exemple de fonctionnement dudit circuit d'émission optique 2 présenté sur la figure 4.

Le déphasage généré par la boucle à verrouillage de retard 80 dépend du nombre de groupes. Dans le cas présenté où le nombre N est égal à quatre, le déphasage est égal à Pi/4.

Par conséquent, la boucle à verrouillage de retard 80 génère, à partir du signal de référence SR en créneaux, quatre signaux de commande SC1 à SC4 comprenant chacun le rapport cyclique de 1/2 et déphasés entre eux de Pi/4 (figure 5). La période P de chaque signal de commande SCi est égale à la période du signal de référence SR.

Si l'on prend comme exemple le cas illustré sur la figure 2 comme exemple, les quatre signaux de commande SC1 à SC4 sont respectivement délivrés aux quatre groupes G1 à G4 de sources optiques qui représentent respectivement 15%, 35%, 35% et 15% du nombre total de sources optiques du réseau 3.

La période P est subdivisée en tranches temporelles successives TTi ayant chacune une durée égale à P/2N, soit ici P/8.

Dans une tranche temporelle initiale TT0 (figures 5 et 6), aucun signal de commande n'est dans l'état haut, de ce fait, aucune diode laser n'est activée et il n'y pas de courant significatif dans les diodes laser du réseau 3.

Dans la première tranche temporelle suivante TT1 (figures 5 et 6), seul le premier signal de commande SC1 est dans l'état haut. Les diodes laser D1 du premier groupe G1 sont par conséquent activées.

Comme le nombre de diodes laser D1 du premier groupe G1 représente 15% du nombre total des diodes du réseau 3, la somme des courants I1 circulant dans les diodes laser activées, ici les diodes D1 du premier groupe G1, forme un premier palier PL1 représentant également 15% du courant total Itotal circulant dans toutes les diodes du réseau 3 lorsqu'elles sont simultanément activées.

L'intensité lumineuse émise est par conséquent également égale à 15% de l'intensité lumineuse totale.

Dans la deuxième tranche temporelle TT2 (figures 5 et 6), les premier et deuxième signaux de commande SC1 et SC2 sont tous les deux dans l'état haut. Les diodes laser D1 et D2 de ces premier et deuxième groupes G1 et G2 sont par conséquent simultanément activées.

La somme des courants I1+I2 circulant dans les diodes laser D1 et D2 activées forme un deuxième palier PL2 représentant un pourcentage cumulatif plus important 50% (15%+35%) du courant total Itotal, ce qui correspond également à 50% de l'intensité lumineuse totale.

Par analogie, dans la troisième tranche temporelle TT3 (figures 5 et 6), les diodes laser D1 à D3 des première, deuxième et troisième groupes G1 à G3 sont simultanément activées.

La somme des courants I1+I2+I3 circulant dans les diodes laser D1 à D3 activées forme un troisième palier PL3 représentant donc un pourcentage cumulatif encore plus important 85% (15%+35%+35%) du courant total Itotal.

De la même façon, toutes les diodes laser D1 à D4 du réseau 3 sont respectivement activées et désactivées dans les quatrième et huitième tranches temporelles TT4 et TT8.

La somme des courants I1+I2+I3+I4 circulant dans les diodes laser activées forme un quatrième palier PL4 représentant l'amplitude crête du courant total Itotal. Comme il n'y pas de courant significatif circulant dans le réseau dans la huitième tranche temporelle TT8, le huitième palier PL8 possède une amplitude en courant à zéro.

De ce fait, dans la période P, le réseau 3 des sources optiques génère un signal optique 5 (figure 6) dont l'amplitude de l'intensité lumineuse (qui correspond à l'amplitude du courant total Itotal) varie par palier PL1 à PL8 sous forme sinusoïdale. Il convient de noter que la valeur crête du courant total Itotal est égale à celle du courant de référence Iref.

Dans l'exemple illustré sur les figures 5 et 6, le point de départ (et le point d'arrivée) de chaque cycle de commande correspond à une activation d'aucun groupe.

Cela étant bien qu'il soit possible d'utiliser un tel point de départ, ce point de départ peut être différent.

Ainsi, en pratique il est préférable de commencer un cycle par une activation d'un nombre initial de groupes contenant ensemble un pourcentage de diodes laser du réseau de diodes laser égal au rapport cyclique R du signal de référence SR, car la valeur moyenne du signal de commande Ictrl est déterminée par ce rapport.

Ainsi dans le cas où le rapport cyclique du signal de référence est égal à 0,5, on commencera de préférence chaque cycle en activant les groupes G1 et G2 qui contiennent ensemble 50% (15%+35%) des diodes laser du réseau 3 de diodes laser.

Ainsi, on obtient un circuit d'émission optique comprenant un réseau de M sources optiques divisé en N groupes de sources optiques, et configuré pour activer ou désactiver cycliquement et séquentiellement ces groupes de façon à obtenir un signal optique dont l'amplitude varie par palier selon une évolution sinusoïdale.

## Revendications

1. Procédé de commande d'un réseau (3) de M sources optiques, les M sources optiques étant réparties en N groupes (G1 à G4), avec N inférieur à M, comprenant des cycles d'activations/désactivations respectives et séquentielles de toutes les sources optiques des N groupes à partir de N signaux de commande (SC1 à SC4) en créneaux périodiques successivement mutuellement déphasés de Pi/N et ayant tous la même période, chaque signal de commande (SC1 à SC4) ayant un premier état, un deuxième état, et un rapport cyclique de 1/2, chaque groupe (G1 à G4) étant activé lorsque le signal de commande (SC1 à SC4) correspondant est dans son premier état et désactivé lorsque le signal de commande (SC1 à SC4) est dans son deuxième état, le nombre de sources optiques dans chaque groupe (G1 à G4) et l'ordonnancement des groupes (G1 à G4) dans la séquence des activations/désactivations étant choisis de façon à générer un signal optique (5) dont l'amplitude varie par palier selon une évolution sinusoïdale.

2. Procédé selon la revendication 1, dans lequel les N signaux de commande (SC1 à SC4) sont générés à partir d'un signal de référence (SR) ayant la même période que celle des signaux de commande (SC1 à SC4) et le courant total (Itotal) circulant dans toutes les sources optiques des N groupes est régulé en fonction du produit d'un courant de référence (Iref) par le rapport cyclique (R) du signal de référence (SR).

3. Procédé selon la revendication 1 ou 2, dans lequel les N signaux de commande (SC1 à SC4) sont générés à partir d'un signal de référence (SR) et chaque cycle de séquences d'activations/désactivations commence par une activation d'un nombre initial de groupes contenant ensemble un pourcentage de sources optiques du réseau de sources optiques égal au rapport cyclique (R) du signal de référence (SR).

4. Procédé selon l'une quelconque des revendications 1 à 3, dans lequel les sources optiques du réseau (3) sont des diodes laser à émission de surface et cavité verticale.

5. Circuit d'émission optique (2), comprenant
un réseau (3) de M sources optiques réparties en N groupes, avec N inférieur à M, et
des moyens de commande (4) configurés pour générer N signaux de commande (SC1 à SC4) en créneaux périodiques successivement mutuellement déphasés de Pi/N et ayant tous la même période, chaque signal de commande (SC1 à SC4) ayant un premier état, un deuxième état, et un rapport cyclique (R) de 1/2, et pour cycliquement activer/désactiver toutes les sources optiques des N groupes respectivement et séquentiellement à partir des N signaux de commande (SC1 à SC4),
chaque groupe (G1 à G4) étant configuré pour être activé lorsque le signal de commande (SC1 à SC4) correspondant est dans son premier état et désactivé lorsque le signal de commande (SC1 à SC4) est dans son deuxième état, le nombre de sources optiques dans chaque groupe (G1 à G4) et l'ordonnancement des groupes (G1 à G4) dans la séquence des activations/désactivations étant choisis de façon à générer un signal optique (5) dont l'amplitude varie par palier selon une évolution sinusoïdale.

6. Circuit (2) selon la revendication 5, dans lequel les moyens de commande (4) comportent une source de signaux (8) configurée pour générer les N signaux de commande (SC1 à SC4) à partir d'un signal de référence (SR) ayant la même période que celle des signaux de commande (SC1 à SC4), et N commutateurs (COM1 à COM4) couplés entre une source d'alimentation (9) commandée par un moyen de régulation (10) et les N groupes de sources optiques, le moyen de régulation étant configuré pour réguler le courant total (Itotal) circulant dans toutes les sources optiques des N groupes en fonction du produit d'un courant de référence (Iref) par le rapport cyclique (R) du signal de référence (SR).

7. Circuit (2) selon la revendication 5 ou 6, dans lequel les moyens de commande (4) comportent une source de signaux (8) configurée pour générer les N signaux de commande (SC1 à SC4) à partir d'un signal de référence (SR) et sont configurés pour faire débuter chaque cycle de séquences d'activations/désactivations par une activation d'un nombre initial de groupes contenant ensemble un pourcentage de sources optiques du réseau de sources optiques égal au rapport cyclique (R) du signal de référence (SR).

8. Circuit (2) selon l'une quelconque des revendications 5 à 7, les moyens de commande (4) comprenant en outre un bloc de commande (11) configuré pour délivrer au moyen de régulation (10) le courant de référence (Iref).

9. Circuit (2) selon l'une quelconque des revendications 5 à 8, dans lequel le moyen de régulation (10) comporte un filtre passe bas ayant une fréquence de coupure dont le rapport avec la fréquence du signal de référence (SR) est inférieur à 1/10.

10. Circuit (2) selon l'une quelconque des revendications 5 à 9, dans lequel les sources optiques d'un même groupe du réseau (3) ne sont mutuellement pas en contact.

11. Circuit (2) selon l'une quelconque des revendications 5 à 10, dans lequel les sources optiques du réseau (3) sont des diodes laser à émission de surface et cavité verticale.

12. Circuit (2) selon l'une quelconque des revendications 5 à 11, réalisé de façon intégrée.

13. Emetteur (T) basé sur le principe du temps de vol indirect et incorporant un circuit d'émission optique (2) selon l'une quelconque des revendications 5 à 12.

14. Appareil électronique (1), par exemple du type tablette ou téléphone mobile cellulaire, incorporant un émetteur (T) selon la revendication 13.

## Patentansprüche

1. Verfahren zum Steuern eines Netzwerks (3) von M optischen Quellen, wobei die M optischen Quellen in N Gruppen (G1 bis G4) verteilt sind, mit N niedriger als M, das jeweilige und sequentielle Zyklen von Aktivierungen/Deaktivierungen aller optischen Quellen der N Gruppen ausgehend von N periodischen Rechtecksteuersignalen (SC1 bis SC4) enthält, die nacheinander gegenseitig um Pi/N phasenverschoben sind und alle die gleiche Periode haben, wobei jedes Steuersignal (SC1 bis SC4) einen ersten Zustand, einen zweiten Zustand und ein Tastverhältnis von 1/2 hat, wobei jede Gruppe (G1 bis G4) aktiviert wird, wenn das entsprechende Steuersignal (SC1 bis SC4) in seinem ersten Zustand ist, und deaktiviert wird, wenn das Steuersignal (SC1 bis SC4) in seinem zweiten Zustand ist, wobei die Anzahl von optischen Quellen in jeder Gruppe (G1 bis G4) und die Ablaufsteuerung der Gruppen (G1 bis G4) in der Folge der Aktvierungen/Deaktivierungen so gewählt werden, dass ein optisches Signal (5) erzeugt wird, dessen Amplitude gemäß einer sinusförmigen Entwicklung stufenweise variiert.

2. Verfahren nach Anspruch 1, wobei die N Steuersignale (SC1 bis SC4) ausgehend von einem Bezugssignal (SR) erzeugt werden, das die gleiche Periode wie die der Steuersignale (SC1 bis SC4) hat, und der in allen optischen Quellen der N Gruppen fließende Gesamtstrom (Itotal) abhängig vom Produkt aus einem Bezugsstrom (Iref) und dem Tastverhältnis (R) des Bezugssignals (SR) geregelt wird.

3. Verfahren nach Anspruch 1 oder 2, wobei die N Steuersignale (SC1 bis SC4) ausgehend von einem Bezugssignal (SR) erzeugt werden, und jeder Folgenzyklus von Aktivierungen/Deaktivierungen durch eine Aktivierung einer Ausgangsanzahl von Gruppen beginnt, die zusammen einen Prozentsatz von optischen Quellen des Netzwerks von optischen Quellen gleich dem Tastverhältnis (R) des Bezugssignals (SR) enthalten.

4. Verfahren nach einem der Ansprüche 1 bis 3, wobei die optischen Quellen des Netzwerks (3) Laserdioden mit Oberflächenemission und Vertikalresonator sind.

5. Optischer Emitterschaltkreis (2), der enthält ein Netzwerk (3) von in N Gruppen verteilten M optischen Quellen, mit N niedriger als M, und Steuereinrichtungen (4), die konfiguriert sind, N periodische Rechtecksteuersignale (SC1 bis SC4) zu erzeugen, die nacheinander gegenseitig um Pi/N phasenverschoben sind und alle die gleiche Periode haben, wobei jedes Steuersignal (SC1 bis SC4) einen ersten Zustand, einen zweiten Zustand und ein Tastverhältnis (R) von 1/2 hat, und alle optischen Quellen der N Gruppen jeweils und sequentiell ausgehend von den N Steuersignalen (SC1 bis SC4) zyklisch zu aktivieren/deaktivieren, jede Gruppe (G1 bis G4) konfiguriert ist, aktiviert zu werden, wenn das entsprechende Steuersignal (SC1 bis SC4) in seinem ersten Zustand ist, und deaktiviert zu werden, wenn das Steuersignal (SC1 bis SC4) in seinem zweiten Zustand ist, wobei die Anzahl von optischen Quellen in jeder Gruppe (G1 bis G4) und die Ablaufsteuerung der Gruppen (G1 bis G4) in der Folge der Aktivierungen/Deaktivierungen so gewählt werden, dass ein optisches Signal (5) erzeugt wird, dessen Amplitude gemäß einer sinusförmigen Entwicklung stufenweise variiert.

6. Schaltkreis (2) nach Anspruch 5, wobei die Steuereinrichtungen (4) eine Signalquelle (8), die konfiguriert ist, die N Steuersignale (SC1 bis SC4) ausgehend von einem Bezugssignal (SR) zu erzeugen, das die gleiche Periode wie diejenige der Steuersignale (SC1 bis SC4) hat, und N Schalter (COM1 bis COM4) aufweisen, die zwischen einer Versorgungsquelle (9), die von einer Regeleinrichtung (10) gesteuert wird, und den N Gruppen von optischen Quellen gekoppelt sind, wobei die Regeleinrichtung konfiguriert ist, den in allen optischen Quellen der N Gruppen fließenden Gesamtstrom (Itotal) abhängig vom Produkt aus einem Bezugsstrom (Iref) und dem Tastverhältnis (R) des Bezugssignals (SR) zu regeln.

7. Schaltkreis (2) nach Anspruch 5 oder 6, wobei die Steuereinrichtungen (4) eine Signalquelle (8) aufweisen, die konfiguriert ist, die N Steuersignale (SC1 bis SC4) ausgehend von einem Bezugssignal (SR) zu erzeugen, und konfiguriert sind, jeden Folgenzyklus von Aktivierungen/Deaktivierungen durch eine Aktivierung einer Ausgangsanzahl von Gruppen beginnen zu lassen, die zusammen einen Prozentsatz von optischen Quellen des Netzwerks von optischen Quellen gleich dem Tastverhältnis (R) des Bezugssignals (SR) enthalten.

8. Schaltkreis (2) nach einem der Ansprüche 5 bis 7, wobei die Steuereinrichtungen (4) außerdem einen Steuerblock (11) enthalten, der konfiguriert ist, den Bezugsstrom (Iref) an die Regeleinrichtung (10) zu liefern.

9. Schaltkreis (2) nach einem der Ansprüche 5 bis 8, wobei die Regeleinrichtung (10) ein Tiefpassfilter mit einer Grenzfrequenz aufweist, deren Verhältnis zur Frequenz des Bezugssignals (SR) niedriger als 1/10 ist.

10. Schaltkreis (2) nach einem der Ansprüche 5 bis 9, wobei die optischen Quellen einer gleichen Gruppe des Netzwerks (3) nicht gegenseitig in Kontakt sind.

11. Schaltkreis (2) nach einem der Ansprüche 5 bis 10, wobei die optischen Quellen des Netzwerks (3) Laserdioden mit Oberflächenemission und Vertikalresonator sind.

12. Schaltkreis (2) nach einem der Ansprüche 5 bis 11, der integriert hergestellt ist.

13. Emitter (T) basierend auf dem indirekten Time-of-Flight-Prinzip und einen optischen Emitterschaltkreis (2) nach einem der Ansprüche 5 bis 12 enthaltend.

14. Elektronisches Gerät (1), zum Beispiel von der Art Tablet-Computer, Mobiltelefon, das einen Emitter (T) nach Anspruch 13 umfasst.

## Claims

1. Method for controlling an array (3) of M optical sources, the M optical sources being distributed in N groups (G1 to G4), with N lower than M, comprising cycles of respective and sequential activations/deactivations of all the optical sources of the N groups using N periodic squarewave control signals (SC1 to SC4) that are successively mutually phase shifted by Pi/N and that all have the same period, each control signal (SC1 to SC4) having a first state, a second state, and a duty cycle of 1/2, each group (G1 to G4) being activated when the corresponding control signal (SC1 to SC4) is in its first state and deactivated when the control signal (SC1 to SC4) is in its second state, the number of optical sources in each group (G1 to G4) and the order of the groups (G1 to G4) in the sequence of the activations/deactivations being chosen so as to generate an optical signal (5) the amplitude of which varies in steps sinusoidally.

2. Method according to Claim 1, wherein the N control signals (SC1 to SC4) are generated from a reference signal (SR) having the same period as that of the control signals (SC1 to SC4) and the total current (Itotal) flowing through all the optical sources of the N groups is regulated depending on the product of a reference current (Iref) multiplied by the duty cycle (R) of the reference signal (SR).

3. Method according to Claim 1 or 2, wherein the N control signals (SC1 to SC4) are generated from a reference signal (SR) and each cycle of sequences of activations/deactivations commences with an activation of an initial number of groups together containing a percentage of optical sources of the array of optical sources equal to the duty cycle (R) of the reference signal (SR).

4. Method according to any one of Claims 1 to 3, wherein the optical sources of the array (3) are vertical cavity surface emitting laser diodes.

5. Optical emitting circuit (2), comprising
an array (3) of M optical sources distributed in N groups, with N lower than M, and
controlling means (4) configured to generate N periodic squarewave control signals (SC1 to SC4) that are successively mutually phase shifted by Pi/N and that all have the same period, each control signal (SC1 to SC4) having a first state, a second state, and a duty cycle (R) of 1/2, and to cyclically activate/deactivate all the optical sources of the N groups respectively and sequentially using the N control signals (SC1 to SC4),
each group (G1 to G4) being configured to be activated when the corresponding control signal (SC1 to SC4) is in its first state and deactivated when the control signal (SC1 to SC4) is in its second state, the number of optical sources in each group (G1 to G4) and the order of the groups (G1 to G4) in the sequence of the activations/deactivations being chosen so as to generate an optical signal (5) the amplitude of which varies in steps sinusoidally.

6. Circuit (2) according to Claim 5, wherein the controlling means (4) include a signal source (8) configured to generate the N control signals (SC1 to SC4) from a reference signal (SR) having the same period as that of the control signals (SC1 to SC4), and N switches (COM1 to COM4) that are coupled between a power source (9) controlled by a regulating means (10) and the N groups of optical sources, the regulating means being configured to regulate the total current (Itotal) flowing through all the optical sources of the N groups depending on the product of a reference current (Iref) multiplied by the duty cycle (R) of the reference signal (SR).

7. Circuit (2) according to Claim 5 or 6, wherein the controlling means (4) includes a signal source (8) configured to generate the N control signals (SC1 to SC4) from a reference signal (SR) and are configured to make each cycle of sequences of activations/deactivations start with an activation of an initial number of groups together containing a percentage of optical sources of the array of optical sources equal to the duty cycle (R) of the reference signal (SR).

8. Circuit (2) according to any one of Claims 5 to 7, the controlling means (4) furthermore comprising a control unit (11) configured to deliver to the regulating means (10) the reference current (Iref).

9. Circuit (2) according to any one of Claims 5 to 8, wherein the regulating means (10) includes a lowpass filter having a cut-off frequency the ratio of which to the frequency of the reference signal (SR) is lower than 1/10.

10. Circuit (2) according to any one of Claims 5 to 9, wherein the optical sources of a given group of the array (3) do not make mutual contact.

11. Circuit (2) according to any one of Claims 5 to 10, wherein the optical sources of the array (3) are vertical cavity surface emitting laser diodes.

12. Circuit (2) according to any one of Claims 5 to 11, produced integratedly.

13. Emitter (T) based on the principle of indirect time-of-flight and incorporating an optical emitting circuit (2) according to any one of Claims 5 to 12.

14. Electronic device (1), for example such as a tablet or cellular mobile telephone, incorporating an emitter (T) according to Claim 13.
